# EUROPEAN PATENT APPLICATION

(11) **EP 4 566 909 A1**
(43) Date of publication of application: **11.06.2025**
(21) Application number: 23874549.1
(22) Date of filing: 22.08.2023
(51) Int. Cl.: B61B 13/00, B61B 3/02, H01L 21/677

(54) **CEILING TRAVELING VEHICLE STOPPING DEVICE AND TRAVELING VEHICLE SYSTEM**

(30) Priority: 05.10.2022 JP 2022161075
(71) Applicant: Murata Machinery, Ltd., Kyoto-shi, Kyoto 601-8326 (JP)
(72) Inventor: ITO, Yasuhisa, Inuyama-shi, Aichi 484-8502 (JP)
(74) Representative: Stöckeler, Ferdinand
(86) International application number: PCT/JP2023/030203
(87) International publication number: WO 2024/075417

(57) **Abstract**

An overhead traveling vehicle stopping device is a stopping device attached to rails provided on a ceiling and configured to stop an overhead traveling vehicle traveling along the travel **route.** The overhead traveling vehicle stopping device includes an engagement part that is engageable with the rail and a body that includes an elongated member that extends downward from the engagement **part.** The body includes a first detectable portion configured to be detected by an obstacle sensor of an overhead traveling vehicle traveling along the first travel route and a second detectable portion configured to be detected by an obstacle sensor of an overhead traveling vehicle traveling along the second travel route parallel to the first travel route in the travel **route.**

## Description

### Technical Field

One aspect of the present invention relates to overhead traveling vehicle stopping devices and traveling vehicle systems.

### Background Art

An overhead traveling vehicle stopping device is known that is attached to rails provided on a ceiling and stops an overhead traveling vehicle traveling along a travel route configured by the rails. As a technology of this kind, Patent Literature 1, for example, describes a stopping device that stops, when being detected by an obstacle sensor of an overhead traveling vehicle, the overhead traveling vehicle. The stopping device described in Patent Literature 1 includes an engagement part engageable with the rail, and an operating rod extending downward from the engagement part and setting the engagement part in either an engaged state or disengaged state with respect to the rail.

### Citation List

### Patent Literature

[Patent Literature 1] Japanese Unexamined Patent Publication No. 2015-131502

### Summary of Invention

### Technical Problem

In the technology described above, when there are a plurality of points at which passage of overhead traveling vehicles has to be prohibited on a travel route, it is necessary to prepare a plurality of stopping devices and to install the stopping devices at those points. Therefore, it is not easy to subject the overhead traveling vehicles to passage prohibition at a plurality of points on the travel route.

One aspect of the present invention is made in view of the above circumstances, and is intended to provide an overhead traveling vehicle stopping device and a traveling vehicle system capable of easily subjecting overhead traveling vehicles to passage prohibition at a plurality of points on a travel route.

### Solution to Problem

(1) An overhead traveling vehicle stopping device according to an aspect of the present invention is a stopping device attached to rails provided on a ceiling and configured to stop an overhead traveling vehicle traveling along a travel route constituted by the rails, the overhead traveling vehicle stopping device including: an engagement part that is engageable with the rail; and a body that includes an elongated member that extends downwardly from the engagement part, in which the body includes a first detectable portion configured to be detected by an obstacle sensor of the overhead traveling vehicle traveling along a first travel route in the travel route, and a second detectable portion configured to be detected by the obstacle sensor of the overhead traveling vehicle traveling along a second travel route parallel to the first travel route in the travel route.

In this overhead traveling vehicle stopping device, when the engagement part is engaged with the rail, in the state in which the overhead traveling vehicle travels along the first travel route, the obstacle sensor of the overhead traveling vehicle detects the first detectable portion and stops the traveling, and in the state in which the overhead traveling vehicle travels along the second travel route, the obstacle sensor of the overhead traveling vehicle detects the second detectable portion and stops the traveling. Therefore, it is possible to prohibit passage on the first travel route and the second travel route that are parallel to each other at points for prohibition thereon, without having to prepare and install the plurality of stopping devices. In other words, it is possible to easily subject the overhead traveling vehicles to passage prohibition at a plurality of points on the travel route.
(2) In the overhead traveling vehicle stopping device described in (1) above, the elongated member may have a bar shape, and the first detectable portion and the second detectable portion may have a flat plate shape. In this case, the elongated member, the first detectable portion, and the second detectable portion can be configured in an uncomplicated manner.
(3) In the overhead traveling vehicle stopping device described in (1) or (2) above, the body may include a first arm member and a second arm member that extend from the elongated member along a direction intersecting the elongated member, the first detectable portion may be provided in the first arm member, and the second detectable portion may be provided in the second arm member. In this case, the first detectable portion and the second detectable portion can be disposed using the first arm member and the second arm member.
(4) In the overhead traveling vehicle stopping device described in any one of (1) to (3) above, the body may be deformable between a deployed state in which the obstacle sensor of the overhead traveling vehicle traveling along the second travel route is capable of detecting the second detectable portion and a retracted state in which the obstacle sensor of the overhead traveling vehicle traveling along the second travel route is unable to detect the second detectable portion. In this case, it is possible to easily adjust points at which the overhead traveling vehicles are subjected to passage prohibition.
(5) In the overhead traveling vehicle stopping device described in any one of (1) to (4) above, the body may include a push-down part that is configured to depress, when coming into contact with an overhead traveling vehicle, a power switch of the overhead traveling vehicle. In this case, it is possible to turn off a power supply of the overhead traveling vehicle having come into contact with the body by the push-down part, to forcibly stop the overhead traveling vehicle.
(6) In the overhead traveling vehicle stopping device described in any one of (1) to (5) above, at least one of the first detectable portion and the second detectable portion may be configured to be removable from the body. In this case, it is possible to easily adjust the points at which the overhead traveling vehicles are subjected to passage prohibition based on detection results of the obstacle sensor.
(7) A traveling vehicle system according to an aspect of the present invention includes: rails that are provided on a ceiling and at least partly disposed in a grid; an overhead traveling vehicle that is configured to travel along the travel route configured by the rails; and the overhead traveling vehicle stopping device according to any one of (1) to (6) that is configured to cause the overhead traveling vehicle traveling along the traveling route to stop. In this traveling vehicle system also, the above-described overhead traveling vehicle stopping device can easily subject the overhead traveling vehicle to passage prohibition at a plurality of points on the travel route.
(8) In the traveling vehicle system described in (7) above, the rails may include a plurality of first straight rails that extend in a first direction, the first direction being a horizontal direction, and a plurality of second straight rails that extend in a second direction, the second direction being a horizontal direction orthogonal to the first direction; when a rectangular area enclosed by a pair of the first straight rails and a pair of the second straight rails is considered as one cell in plan view, the first detectable portion may be detected by the obstacle sensor of the overhead traveling vehicle traveling along a first travel route, the first travel route being the travel route passing through a first cell, and the second detectable portion may be detected by the obstacle sensor of the overhead traveling vehicle traveling along a second travel route, the second travel route being the travel route passing through a second cell adjacent to the first cell; and the body may include a third detectable portion configured to be detected by the obstacle sensor of the overhead traveling vehicle traveling along a third travel route, the third travel route being the travel route passing through a third cell adjacent to the first cell on an opposite side to a second cell side, and a fourth detectable portion configured to be detected by the obstacle sensor of the overhead traveling vehicle traveling along a fourth travel route, the fourth travel route being the travel route passing through a fourth cell adjacent to the second cell on an opposite side to a first cell side. In this case, in a so-called grid system, the overhead traveling vehicle stopping device can exert passage prohibition on each of the first to fourth travel routes that are parallel to each other.
(9) In the traveling vehicle system described in (8) above, the body may be deformable between a first deployed state in which the obstacle sensor of the overhead traveling vehicle traveling along the third travel route is capable of detecting the third detectable portion and the obstacle sensor of the overhead traveling vehicle traveling along the fourth travel route is capable of detecting the fourth detectable portion, a second deployed state in which the obstacle sensor of the overhead traveling vehicle traveling along the third travel route is unable to detect the third detectable portion and the obstacle sensor of the overhead traveling vehicle traveling along the fourth travel route is capable of detecting the fourth detectable portion, and a retracted state in which the obstacle sensor of the overhead traveling vehicle traveling along the third travel route is unable to detect the third detectable portion and the obstacle sensor of the overhead traveling vehicle traveling along the fourth travel route is unable to detect the fourth detectable portion. In this case, it is possible to easily adjust points at which the overhead traveling vehicles are subjected to passage prohibition.
(10) In the traveling vehicle system described in (9) above, the body may include a first arm member and a second arm member that extend from the elongated member along a direction intersecting the elongated member, the first arm member may include a first fixed part and a first movable part that is foldably connected to a tip side of the first fixed part via a first hinge, the second arm member may include a second fixed part and a second movable part that is foldably connected to a tip side of the second fixed part via a second hinge, the first detectable portion may be provided on the first fixed part, the second detectable portion may be provided on the second fixed part, the third detectable portion may be provided on the first movable part, and the fourth detectable portion may be provided on the second movable part. In this case, a folding structure allows adjustment of the points at which the overhead traveling vehicles are subjected to passage prohibition to be specifically implementable.
(11) In the traveling vehicle system described in (10) above, the first movable part may rotate about the first hinge in one rotation direction from between either clockwise or counterclockwise in plan view, the second movable part may rotate about the second hinge in another rotation direction from between either clockwise or counterclockwise in plan view, and the connecting point of the first arm member at the elongated member may be separated from the connecting point of the second arm member at the elongated member in a longitudinal direction of the elongated member. In this case, the first and the second movable parts can be folded so as to overlap each other in plan view.
(12) In the traveling vehicle system described in any one of (7) to (11) above, the rails include a plurality of straight rails and an intersecting rail that is disposed so as to be adjacent to each of ends of the straight rails in a horizontal direction with a gap, and the engagement part may be engaged with a pair of the straight rails that extend in the same direction and are aligned so as to be close to or come into contact with each other, may be passable through the gap in a vertical direction, may have a C-shape open upwardly when viewed from a direction along the pair of straight rails, and may include a contact portion that is in contact with an upper surface of each of the pair of straight rails. In this case, engagement of the engagement part to the rail is specifically implementable in the so-called grid system.
(14) In the traveling vehicle system described in any one of (7) to (11) above, the rails may include a plurality of straight rails, and the engagement part may be engaged with a pair of the straight rails that extend in the same direction and are aligned so as to be close to each other, and may include an insertion part that is inserted between the pair of straight rails and a contact portion that is connected to an upper side of the insertion part and in contact with an upper surface of each of the pair of straight rails. In this case, engagement of the engagement part to the rail is specifically implementable in the so-called grid system.

### Advantageous Effects of Invention

According to an aspect of the present invention, it is possible to provide an overhead traveling vehicle stopping device and a traveling vehicle system capable of easily subjecting overhead traveling vehicles to passage prohibition at a plurality of points on a travel route.

### Brief Description of Drawings

[FIG. 1] FIG. 1 is a perspective diagram illustrating a traveling vehicle system according to an embodiment.
[FIG. 2] FIG. 2 is a side view illustrating an overhead traveling vehicle in FIG. 1.
[FIG. 3] FIG. 3 is a front view illustrating a fully deployed state of an overhead traveling vehicle stopping device according to an embodiment.
[FIG. 4] FIG. 4 is a cross-sectional view illustrating an engagement part in FIG. 3.
[FIG. 5] FIG. 5 is a plan view for explaining an engagement to grid rail of the engagement part in FIG. 3.
[FIG. 6] FIG. 6(a) is a cross-sectional view along the VI-VI line of FIG. 3. FIG. 6(b) is a front view illustrating part of the overhead traveling vehicle stopping device in FIG. 3 by enlargement.
[FIG. 7] FIG. 7 is a front view illustrating a semi-deployed state of the overhead traveling vehicle stopping device according to the embodiment.
[FIG. 8] FIG. 8(a) is a cross-sectional view corresponding to a cross-section of FIG. 6(a) in the overhead traveling vehicle stopping device in FIG. 7. FIG. 8(b) is a front view illustrating part of the overhead traveling vehicle stopping device in FIG. 7 by enlargement.
[FIG. 9] FIG. 9 is a front view illustrating a retracted state of the overhead traveling vehicle stopping device according to the embodiment.
[FIG. 10] FIG. 10(a) is a cross-sectional view corresponding to the cross-section of FIG. 6(a) in the overhead traveling vehicle stopping device in FIG. 9. FIG. 10(b) is a front view illustrating part of the overhead traveling vehicle stopping device in FIG. 9 by enlargement.
[FIG. 11] FIG. 11(a) is a plan view of the grid rail for explaining a fully deployed state of the overhead traveling vehicle stopping device. FIG. 11(b) is a plan view of the grid rail for explaining a semi-deployed state of the overhead traveling vehicle stopping device. FIG. 11(c) is a plan view of the grid rail for explaining the retracted state of the overhead traveling vehicle stopping device.
[FIG. 12] FIG. 12(a) is a plan view of the grid rail for explaining a use example of the overhead traveling vehicle stopping device. FIG. 12(b) is a plan view of the grid rail for explaining another use example of the overhead traveling vehicle stopping device. FIG. 12(c) is a plan view of the grid rail for further explaining another use example of the overhead traveling vehicle stopping device.
[FIG. 13] FIG. 13(a) is a front view illustrating a cart configured to accommodate the overhead traveling vehicle stopping device. FIG. 13(b) is a side view of the cart configured to accommodate the overhead traveling vehicle stopping device.
[FIG. 14] FIG. 14 is a cross-sectional view along the XIV-XIV line of FIG. 13(b).
[FIG. 15] FIG. 15 is a cross-sectional view illustrating an engagement part according to a modification.
[FIG. 16] FIG. 16(a) is a front view illustrating the engagement part in FIG. 15. FIG. 16(b) is a plan view illustrating the engagement part in FIG. 15. FIG. 16(c) is a side view illustrating the engagement part in FIG. 15.
[FIG. 17] FIG. 17 is a front view illustrating a fully deployed state of the overhead traveling vehicle stopping device according to the modification.

### Description of Embodiments

The following describes the embodiment with reference to the drawings. In the following description, identical or equivalent elements will be marked with the same symbol, and redundant explanations will be omitted. In the drawings, for convenience of explanation, each configuration according to the embodiment is represented at a different scale as appropriate. In some drawings, the XYZ Cartesian coordinate system is shown alongside. In the description hereafter, one direction along the horizontal plane is an X direction (first direction), a direction orthogonal to the X direction and along a horizontal plane is a Y direction (second direction), and a vertical direction is a Z direction.

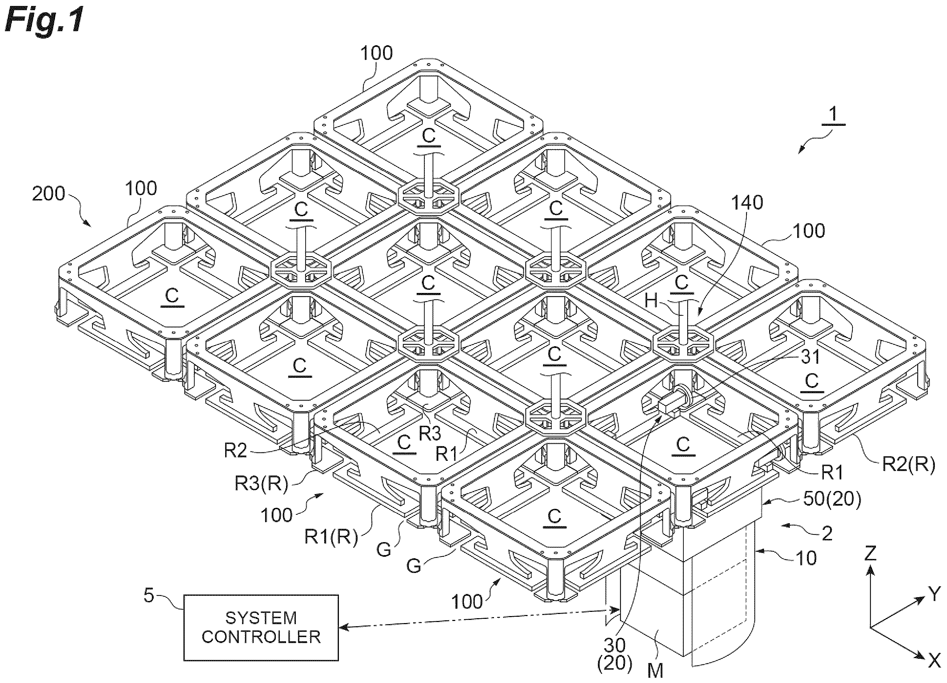

As illustrated in FIG. 1, the traveling vehicle system 1 according to the embodiment is a grid system for transporting articles M by an overhead traveling vehicle 2 in a clean room of a semiconductor manufacturing plant, for example. The traveling vehicle system 1 includes, for example, a plurality of the overhead traveling vehicles 2, a system controller 5 configured to control the overhead traveling vehicles 2, and a grid rail (rail) R on which the overhead traveling vehicles 2 travel. The article M is, for example, a front opening unified pod (FOUP) configured to accommodate a semiconductor wafer, or a reticle pod or the like configured to accommodate a reticle. The overhead traveling vehicle 2 may be referred to as a cart, a transport vehicle, a transfer cart, or a traveling cart, or the like.

The grid rail R is provided on or near a ceiling of a building such as a clean room. The grid rail R extends along the horizontal direction and is formed in a grid in plan view. The grid rail R includes a plurality of first rails R1 extending in the X direction, a plurality of second rails R2 extending in the Y direction, and an intersection rail R3 disposed at a portion corresponding to an intersection of the first rail R1 and the second rail R2. The upper surfaces of the first rail R1, the second rail R2, and the intersection rail R3 constitute a flat and horizontal travel surface. The first rail R1 constitutes the first straight rail (straight rail) and the second rail R2 constitutes the second straight rail (straight rail).

In the grid rail R, a plurality of the first rails R1 extend in a series at intervals in the X direction and a plurality of the second rails R2 extend in a series at intervals in the Y direction. Two intersection rails R3 are placed between one first rail R1 and another first rail R1 on the X direction line. Two intersection rails R3 are placed between one second rail R2 and another second rail R2 on the Y direction line. A plurality of the first rails R1, a plurality of the second rails R2, and a plurality of the intersection rails R3 are disposed with a predetermined gap G between each other. In other words, the intersection rail R3 is disposed adjacent to each of the ends of the first and the second rails R1 and R2 in the horizontal direction with a gap G therebetween.

In the present embodiment, the grid rail R is constructed by a plurality of rail units 100 aligned in the X direction and the Y direction. Each of the rail units 100 has a rectangular shape in plan view. Each rail unit 100 includes a pair of the first rails R1, R1 constituting opposite sides of the rectangle, a pair of the second rails R2, R2 constituting other opposite sides of the rectangle, and the four intersection rails R3 constituting the four corners of the rectangle. In each rail unit 100, the first rail R1, the second rail R2, and the intersection rail R3 are supported by support walls and support columns, or the like.

The rail units 100 are suspended from an unillustrated ceiling or the like by a plurality of suspension members H while being connected to each other by connecting members 140. In each rail unit 100, a rectangular area (square) that is rectangular in plan view is surrounded by an opposing pair of the first rails R1, R1 and an opposing pair of the second rails R2, R2 constitutes one cell C.

A shape and a range (layout) of the grid rail R may be adjusted or modified as appropriate by the rail units 100 being arranged in any desired layout. The grid rail R constitutes a travel route on which the overhead traveling vehicle 2 travels. The travel route is set to pass through (connect) a plurality of the cells C in plan view. In a grid system, a plurality of the travel routes can be set up depending on the number of cells C.

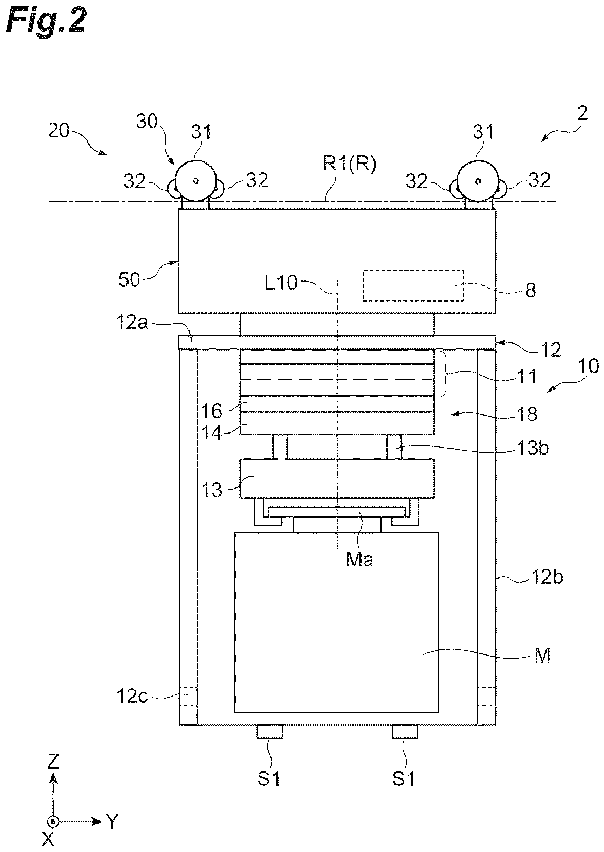

As illustrated in FIG. 1 and FIG. 2, the overhead traveling vehicle 2 is communicatively connected to the system controller 5 via a communication system (unillustrated). The overhead traveling vehicle 2 travels along a travel route constituted by the grid rail R. The overhead traveling vehicle 2 has a traveling cart 20 traveling on the grid rail R and a body 10 configured to be attached to a lower part of the traveling cart 20 and to be turnable with respect to the traveling cart 20. The traveling cart 20 includes a cart unit 50 disposed below the grid rail R and a traveling section 30 provided at the four corner positions on the cart unit 50 in plan view. The cart unit 50 is suspended from the grid rail R via the traveling section 30. Inside the cart unit 50 is a cart controller (control section) 8.

The body 10 is turnable around a rotation axis L10 in the Z direction with respect to the cart unit 50. The body 10 has a body frame 12 formed in a cylindrical shape, for example. The body frame 12 includes a top plate 12a of a disc shape and a cylindrical frame 12b hanging from a periphery of the top plate 12a. The body frame 12 has a shape with a lower surface opened. The body 10 includes a transfer device 18 disposed inside the body frame 12.

The transfer device 18 moves along the horizontal direction with respect to the traveling section 30 and transfers articles M to and from, for example, a load port (loading platform). The transfer device 18 is rotatable around the rotation axis L10. The transfer device 18 has an article holding section 13 configured to hold an article **M,** a lifting drive section 14 configured to lift up and down the article holding section 13 in the Z direction, and a horizontal slide-out mechanism 11 configured to move the lifting drive section 14 in the horizontal direction. Between the horizontal slide-out mechanism 11 and the lifting drive section 14 is provided a rotary drive section 16 configured to rotate and drive the lifting drive section 14 with respect to the horizontal slide-out mechanism 11 around a rotation axis along the Z-direction.

The traveling section 30 has four traveling wheels 31. Each of the traveling wheels 31 has two auxiliary wheels 32. The traveling wheels 31 are driven rotationally by the driving force of a traveling drive motor (unillustrated). The traveling wheels 31 roll on the grid rail R. The auxiliary wheels 32 are disposed one each in front of and behind the traveling wheels 31 in a traveling direction. The four traveling wheels 31 are steered by a wheel turning mechanism (unillustrated). This makes it possible to switch a traveling direction of the overhead traveling vehicle 2 between the X direction and the Y direction.

The cart controller 8 totally controls the overhead traveling vehicle 2. The cart controller 8 is provided in the cart unit 50, for example. The cart controller 8 controls the traveling of the overhead traveling vehicle 2 based on a transport command. The cart controller 8 controls a transfer operation of the overhead traveling vehicle 2 based on the transfer command. The system controller 5 selects any of the overhead traveling vehicles 2 configured to be able to transport the articles M and assigns the transport command to the selected overhead traveling vehicle 2. The transport command includes a travel command to execute traveling of the overhead traveling vehicle 2 to the load port, and a grab command for an article M disposed at the load port or an unload command to unload a held article M onto the load port.

As illustrated in FIG. 2, the overhead traveling vehicle 2 has an obstacle sensor S1. The overhead traveling vehicle 2 is configured such that the traveling of the overhead traveling vehicle 2 is stoppable based on a detection result of the obstacle sensor S1. The obstacle sensor S1 detects an obstacle located in front of the overhead traveling vehicle 2 in the traveling direction thereof. The obstacle sensor S1 is provided at the lower part of the cylindrical frame 12b. The obstacle sensor S1 is, for example, an optical sensor configured to detect an obstacle by emitting a detection light. An emission area of the detection light may be linear, banded, or radial. The obstacle sensor S1 may be a sensor configured to be capable of detecting the distance from the obstacle sensor S1. The detection result at the obstacle sensor S1 is obtained by the cart controller 8. The cart controller 8, when detecting an obstacle, the distance from which to the overhead traveling vehicle 2 is not more than a specified distance by the obstacle sensor S1, stops the traveling of the overhead traveling vehicle 2.

The overhead traveling vehicle 2 has a tape switch (power switch) 12c. The tape switch 12c is a contact sensor configured to detect contact with the overhead traveling vehicle 2. The tape switch 12c outputs a signal, for example, when detecting contact with a pusher 80 described below. The overhead traveling vehicle 2 stops traveling by turning off the power supply, for example, when contact with the pusher 80 is detected by the tape switch 12c.

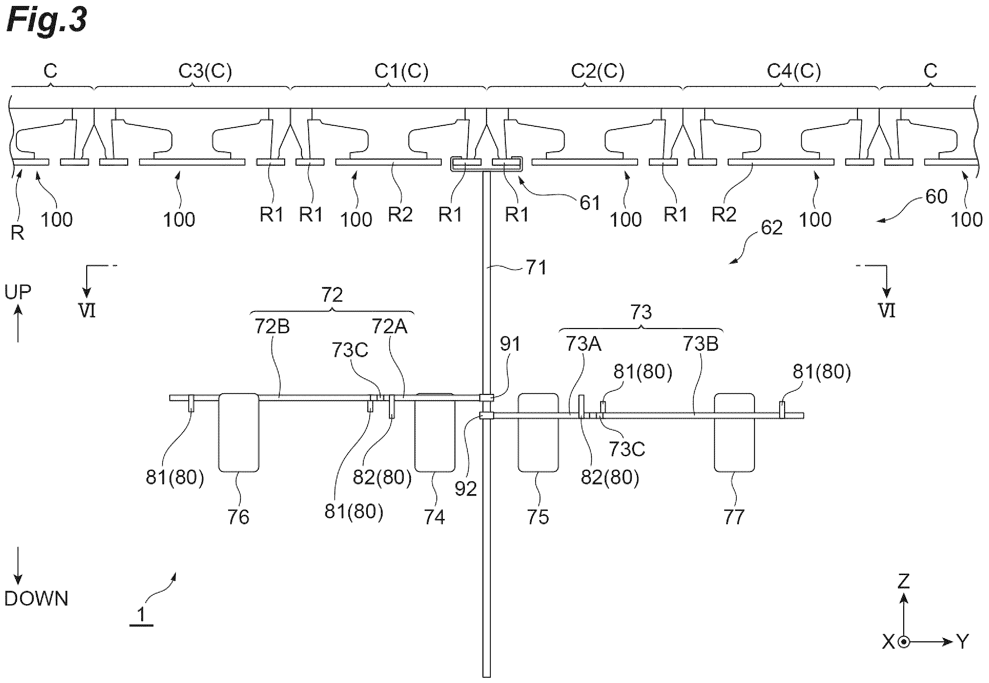

As illustrated in FIG. 3, the traveling vehicle system 1 according to the present embodiment includes an overhead traveling vehicle stopping device 60. The following specifically describes the overhead traveling vehicle stopping device 60.

The overhead traveling vehicle stopping device 60 is a stopping device configured to stop the overhead traveling vehicle 2 traveling along the travel route. The overhead traveling vehicle stopping device 60 is removably attached to the grid rail R. The overhead traveling vehicle stopping device 60 includes an engagement part 61 and a body 62. In the following, the vertical direction is referred to as an "up-down direction", one horizontal direction is referred to as a "left-right direction", and another horizontal direction perpendicular to the left-right direction is referred to as a "front-back direction".

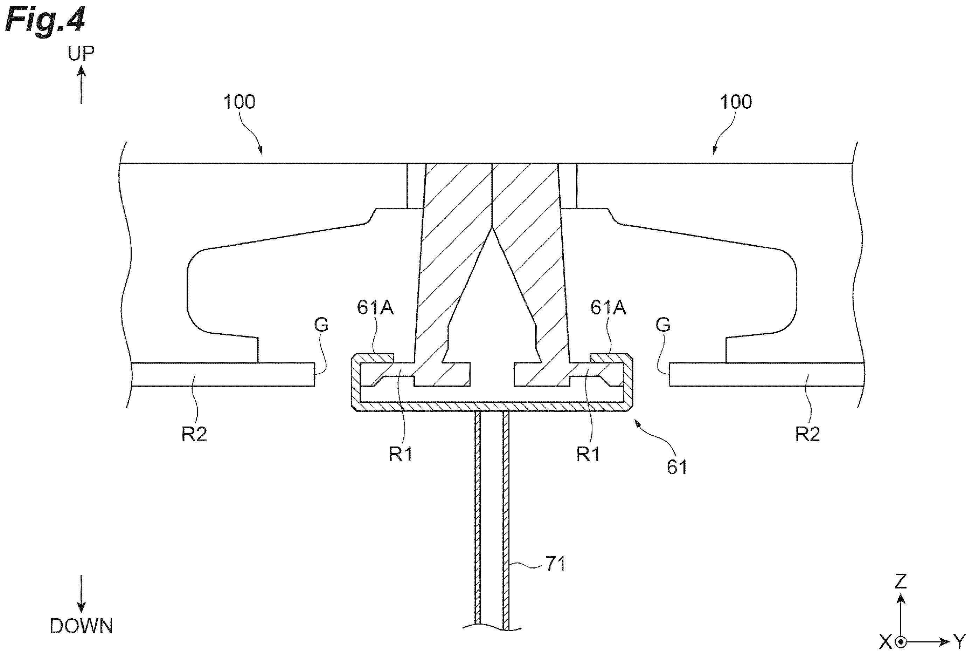

As illustrated in FIG. 4, the engagement part 61 is a member engageable with the grid rail R. In the example illustrated in the drawing, the engagement part 61 engages a pair of the first rails R1, R1 extending along the same X direction and being aligned in the Y direction so as to be close to each other (hereinafter also simply referred to as "the pair of first rails R1, R1"). The pair of first rails R1, R1 being close in the Y direction are the first rail R1 included in one rail unit 100 and the first rail R1 included in the other rail unit 100 of the pair of rail units 100 adjacent to each other in the Y direction. The pair of first rails R1, R1 may come into contact with each other in the Y direction.

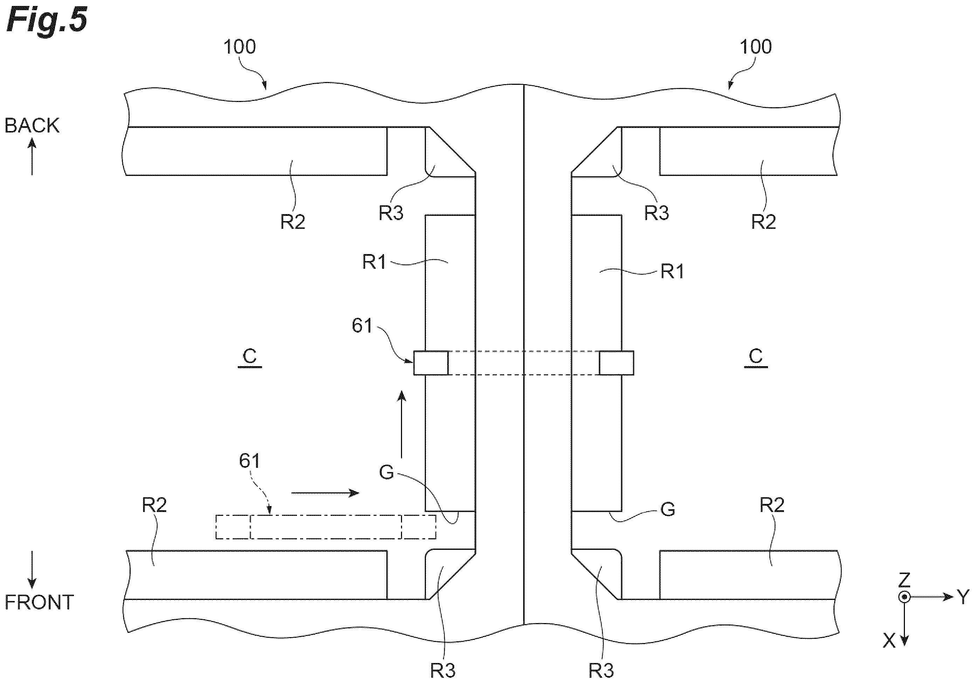

The engagement part 61 is a C hook of a C shape open upwardly when viewed from the front-back direction along the first rail R1. The engagement part 61 has a bent plate shape made by bending a plate material. The engagement part 61 includes a contact portion 61A being in contact with (contacting and touching) the outside of the upper surface of each of the pair of first rails R1, R1 in the width direction. The contact portion 61A is constituted by an upper part of the engagement part 61 and includes a flat surface touching the upper surface of each first rail R1. As illustrated in FIG. 5, the engagement part 61 has a width shorter than the gap G in the front-back direction and is passable through the gap G in the up-down direction. The engagement part 61 is engaged so as to be hanged in a central part of the pair of first rails R1, R1 in the longitudinal direction.

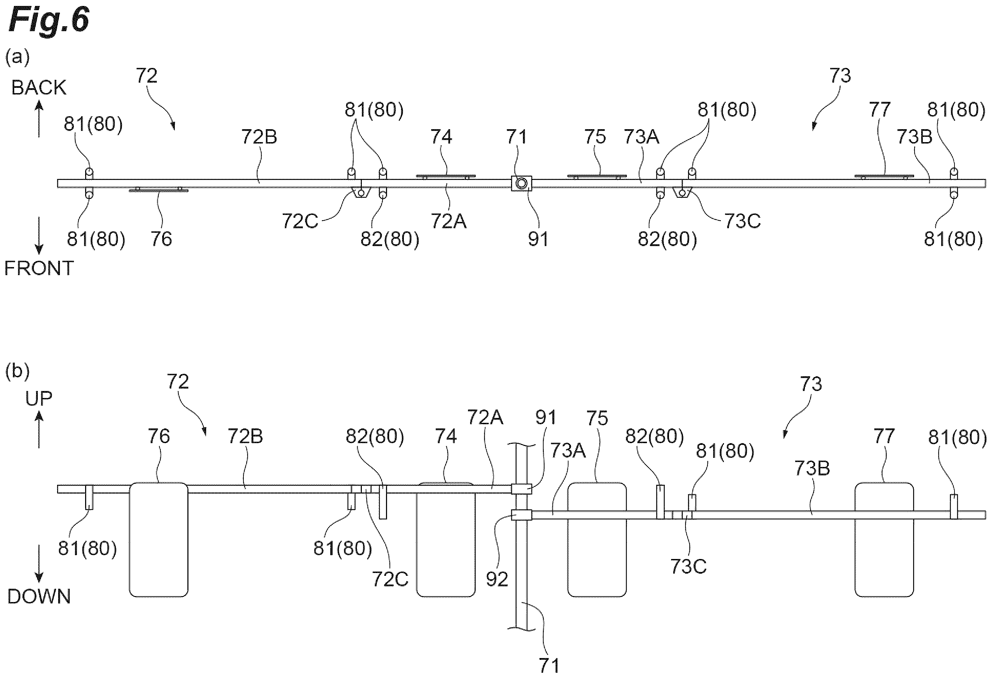

As illustrated in FIG. 3, FIG. 6(a), and FIG. 6(b), the body 62 includes a pole (elongated member) 71, a first beam (first arm member) 72, a second beam (second arm member) 73, a first reflector (first detectable portion) 74, a second reflector (second detectable portion) 75, a third reflector (third detectable portion) 76, a fourth reflector (fourth detectable portion) 77, and a plurality of pushers (push-down parts) 80.

The pole 71 has a rod-shape extending downward from the engagement part 61. The pole 71 is a circular tubular member, the up-down direction of which is the axis direction. The pole 71 is about 2 m long, for example. An upper end of the pole 71 is fixed at a position as a center in the left-right direction and also a center in the front-back direction on the lower surface of the engagement part 61. The axis direction of the pole 71 is perpendicular to a lower surface of the engagement part 61.

As illustrated in FIG. 3, FIG. 7, FIG. 8(a), and FIG. 8(b), the first beam 72 and the second beam 73 have a rod shape extending from the pole 71 along the left-right directions. The first beam 72 extends from the pole 71 to one side in the left-right direction. The first beam 72 includes a first fixed beam (first fixed part) 72A connected to the pole 71 and a first movable beam (first movable part) 72B connected to a tip side of the first fixed beam 72A.

The first fixed beam 72A is a circular tubular member, the left-right direction of which is the axis direction. The first fixed beam 72A extends from the pole 71 toward one side in the left-right direction. The base side of the first fixed beam 72A is fixed to the pole 71 via a connecting part (connecting point) 91. The first fixed beam 72A is located directly below the first cell C1, which is the cell C formed by whichever of the pair of first rails R1, R1, to which the engagement part 61 is engaged.

The first movable beam 72B is a circular tubular member similar to the first fixed beam 72A. The base side of the first movable beam 72B is connected to the tip side of the first fixed beam 72A via a hinge (first hinge) 72C. The first movable beam 72B moves in a pivoting motion with a shaft along the up-down direction of the hinge 72C as a base axis. Specifically, the first movable beam 72B is movable such that its tip moves counterclockwise and clockwise toward a front side in plan view. In other words, the first movable beam 72B rotates clockwise and counterclockwise in plan view around the hinge 72C.

This makes it possible to configure the first beam 72 such that the first movable beam 72B on the tip side is foldable via the hinge 72C with respect to the first fixed beam 72A on the base side. Hereinafter, a state in which the first movable beam 72B extends parallel to the first fixed beam 72A (the first movable beam 72B is not folded into the first fixed beam 72A) is also referred to as an open state of the first beam 72. The first movable beam 72B is located directly below the third cell C3 which is the cell C adjacent to a side away from the pole 71 in the left-right direction with respect to the first cell C1, when the first beam 72 is in the open state. The hinge 72C is not limited to any particular hinge, and for example, a torque hinge (free stop hinge) may be used.

As illustrated in FIG. 3, FIG. 9, FIG. 10(a), and FIG. 10(b), the second beam 73 extends from the pole 71 to the other side in the left-right direction. The second beam 73 includes a second fixed beam (second fixed part) 73A connected to the pole 71 and a second movable beam (second movable part) 73B connected to a tip side of the second fixed beam 73A. The second fixed beam 73A is a circular tubular member, the left-right direction of which is the axis direction. The second fixed beam 73A extends from the pole 71 toward the other side in the left-right direction. The base side of the second fixed beam 73A is fixed to the pole 71 via the connecting part (connecting point) 92. The second fixed beam 73A is located directly below the second cell C2, which is the cell C formed by whichever other of the pair of first rails R1, R1, to which the engagement part 61 is engaged.

The second movable beam 73B is a circular tubular member similar to the second fixed beam 73A. The base side of the second movable beam 73B is connected to the tip side of the second fixed beam 73A via a hinge (second hinge) 73C. The second movable beam 73B moves in a pivoting motion with a shaft along the up-down direction of the hinge 73C as a base axis. Specifically, the second movable beam 73B moves such that its tip moves clockwise and counterclockwise toward the front side in plan view. In other words, the second movable beam 73B turns around the hinge 73C in another rotation direction from between either clockwise or counterclockwise in plan view.

This makes it possible to configure the second beam 73 such that the second movable beam 73B on the tip side is foldable via the hinge 73C with respect to the second fixed beam 73A on the base side. In the following, the state in which the second movable beam 73B extends parallel to the second fixed beam 73A (state in which the second movable beam 73B is not folded into the second fixed beam 73A) is also referred to as an open state of the second beam 73. The second movable beam 73B is located directly below the fourth cell C4, which is the cell C adjacent to the side away from the pole 71 in the left-right direction with respect to the second cell C2, when the second beam 73 is in the open state. The hinge 73C is not limited to any particular hinge, and for example, a torque hinge may be used.

The connecting part 91 of the first beam 72 at pole 71 is separated from the connecting part 92 of the first beam 72 at the pole 71 by a predetermined length in the up-down direction. The predetermined length is greater than outer diameters of the first beam 72 and the second beam 73.

As illustrated in FIG. 3, FIG. 6(a), and FIG. 6(b), the first and the third reflectors 74, 76 are provided on the first beam 72. The second and the fourth reflectors 75, 77 are provided on the second beam 73. The first to the fourth reflectors 74 to 77 have a rectangular flat plate shape of a color (for example, white) with a certain level or greater reflectance of the light of the obstacle sensor S1.

The first reflector 74 is provided on the first fixed beam 72A. The first reflector 74, the thickness direction of which is a front-back direction, has an upper end portion removably fixed to the rear side of the first fixed beam 72A with a screw or the like. The first reflector 74 is located directly below the first cell C1. The first reflector 74 is detected by the obstacle sensor S1 of the overhead traveling vehicle 2 traveling along a first travel route, the first travel route being the travel route passing through the first cell C1 in the front-back direction. The front-back direction corresponds to the extending direction of the first rail R1 to which the engagement part 61 is engaged.

The second reflector 75 is provided on the second fixed beam 73A. The second reflector 7, the front-back direction of which is the thickness direction, is removably fixed to the rear side of the second fixed beam 73A with a screw or the like. The second reflector 75 is disposed so as to be at the same position as the first reflector 74 is in the up-down direction. The second reflector 75 is disposed directly below the second cell C2. The second reflector 75 is detected by the obstacle sensor S1 of the overhead traveling vehicle 2 traveling along a second travel route, the second travel route being a travel route parallel to the first travel route and passing through the second cell C2 in the front-back direction.

The third reflector 76 is provided on the first movable beam 72B. The third reflector 76, the front-back direction of which is the thickness direction, is removably fixed to the front side of the first movable beam 72B with a screw or the like when the first beam 72 is in the open state. The third reflector 76 is disposed so as to be at the same position as the first and the second reflectors 74, 75 are in the up-down direction. The third reflector 76 is disposed directly below the third cell C3. The third reflector 76 is detected by the obstacle sensor S1 of the overhead traveling vehicle 2 traveling along the third travel route which is a travel route parallel to the first travel route and passing through the third cell C3 in the front-back direction.

The fourth reflector 77 is provided on the second movable beam 73B. The fourth reflector 77, the front-back direction of which is the thickness direction, is removably fixed to the rear side of the second movable beam 73B with a screw or the like when the second beam 73 is in the open state. The fourth reflector 77 is disposed so as to be at the same position as the first to the third reflectors 74 to 76 are in the up-down direction. The fourth reflector 77 is disposed directly below the fourth cell C4. The fourth reflector 77 is detected by the obstacle sensor S1 of the overhead traveling vehicle 2 traveling along the fourth travel route which is a travel route parallel to the second travel route and passing through the fourth cell C4 in the front-back direction.

The pusher 80 is a member configured to press down, when coming into contact with the overhead traveling vehicle 2, the tape switch 12c of the overhead traveling vehicle **2.** The pusher 80 is a circular tubular member, the up-down direction of which is the axial direction. The pusher 80 is removably fixed to the first and the second beams 72, 73 via the attachment part. The pusher 80 is disposed at a position further away from the first and the second beams 72, 73 than the first to the fourth reflectors 74 to 77 are in the front-back direction. The pusher 80 includes first pushers 81 and second pushers 82 that are longer than the first pushers 81.

The first pushers 81 are provided at the rear side of the tip of the first fixed beam 72A (the end on a side away from the pole 71), at the rear side of the base of the first movable beam 72B, and at the front side and the rear side of the tip of the first movable beam 72B, respectively, when the first beam 72 is in the open state. The lower end of the first pusher 81 provided on the first beam 72 is located above the second beam 73. The first pushers 81 are located at the rear side of the tip of the second fixed beam 73A, at the rear side of the base of the second movable beam 73B, and at the front side and the rear side of the tip of the second movable beam 73B, respectively, when the second beam 73 is in the open state. The upper end of the first pusher 81 provided on the second beam 73 is located lower than that on the first beam 72.

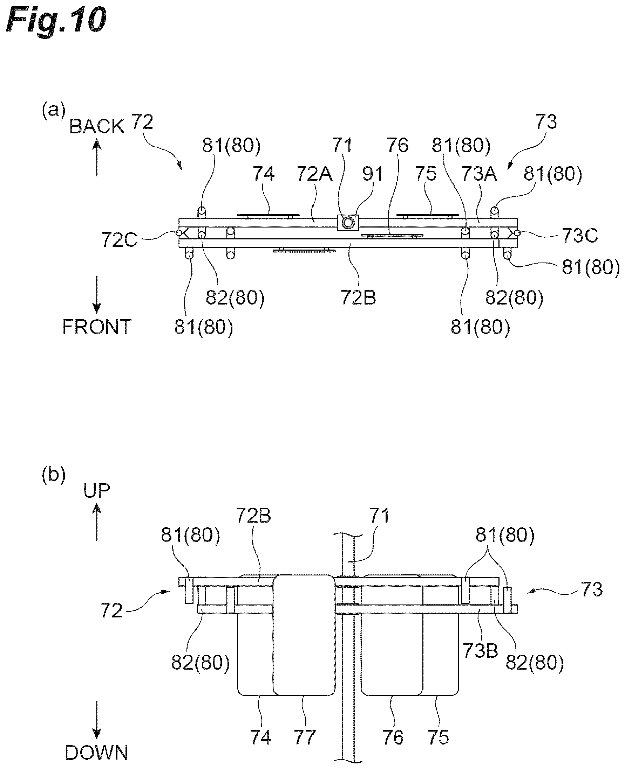

The second pushers 82 are provided on the front side of the tip of the first fixed beam 72A and on the front side of the tip of the second fixed beam 73A. The lower end of the second pusher 82 provided on the first beam 72 is lower than that on the second beam 73. The second pusher 82 functions as a stopper configured to prevent the first movable beam 72B of the first beam 72 in the closed state from moving to come into contact with the first fixed beam 72A (see FIG. 10(a)). The upper end of the second pusher 82 provided on the second beam 73 is located above the first beam 72. The second pusher 82 functions as a stopper configured to prevent the second movable beam 73B of the second beam 73 in the closed state from moving to come into contact with the second fixed beam 73A (see FIG. 10(a)).

In the above configuration, as illustrated in FIG. 3, FIG. 6(a), and FIG. 6(b), the first movable beam 72B is in the open state of not being folded and extending along the first fixed beam 72A, and the second movable beam 73B is in the open state of not being folded and extending along the second fixed beam 73A, so that it is possible to put the body 62 in a fully deployed state (first deployed state: four-cell type). In the fully deployed state, the obstacle sensor S1 of the overhead traveling vehicle 2 traveling along the first to the fourth travel routes respectively passing through the first to the fourth cells C1 to C4 are capable of respectively detecting the first to the fourth reflectors 74 to 77. Furthermore, in the fully deployed state, in the state in which the overhead traveling vehicle 2 comes into contact with the body 62, the pusher 80 is capable of pressing down the tape switch 12c of the overhead traveling vehicle 2 to stop the overhead traveling vehicle 2 in an emergency.

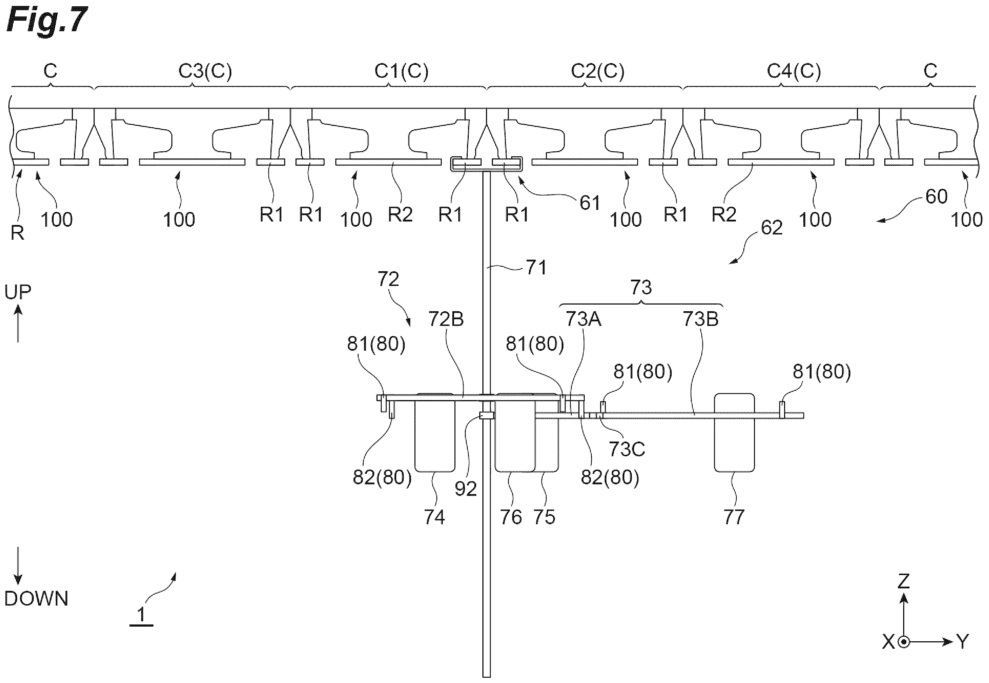

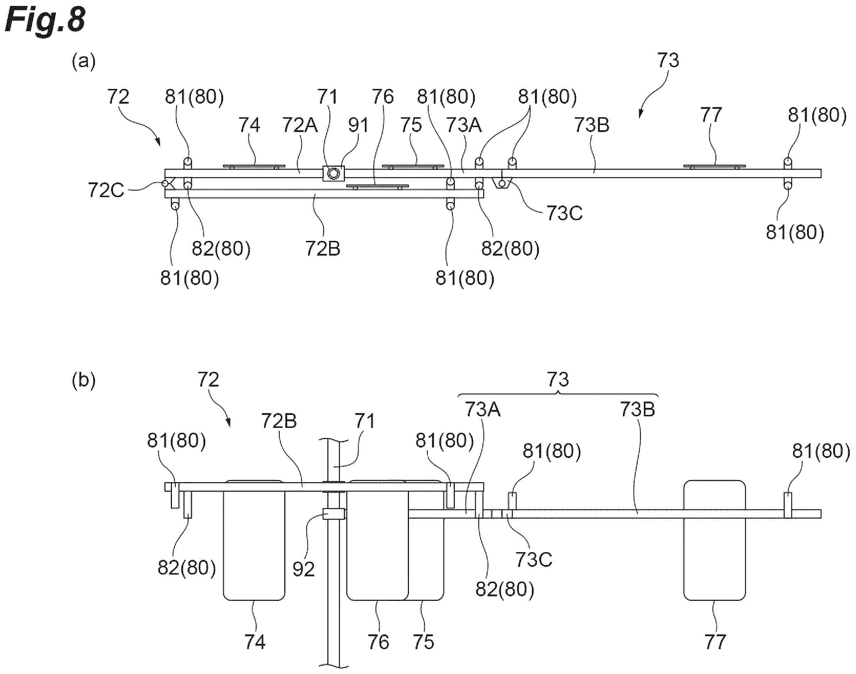

As illustrated in FIG. 7, FIG. 8(a), and FIG. 8(b), from the fully deployed state, the first movable beam 72B is rotated around the hinge 72C counterclockwise in plan view and the first movable beam 72B is folded and in the closed state, so that it is possible to deform the body 62 to the next semi-deployed state (second deployed state: three-cell type). In the semi-deployed state, the obstacle sensor S1 of the overhead traveling vehicle 2 traveling along the first, the second, and the fourth travel routes respectively passing through the first, the second, and the fourth cells C1, C2, and C4 is capable of respectively detecting the first, the second, and the fourth reflectors 74, 75, and 77, and the third obstacle sensor S1 of the overhead traveling vehicle 2 traveling along the third travel route passing through the third cell C3 is unable to detect the third reflector 76. Furthermore, in the semi-deployed state, in the case where the overhead traveling vehicle 2 comes into contact with the body 62, the pusher 80 is capable of pressing down the tape switch 12c of the overhead traveling vehicle 2 to stop the overhead traveling vehicle 2 in an emergency. In the semi-deployed state, the second pusher 82 of the first fixed beam 72A functions as a stopper and prevents the first movable beam 72B from rotating more than necessary counterclockwise in plan view.

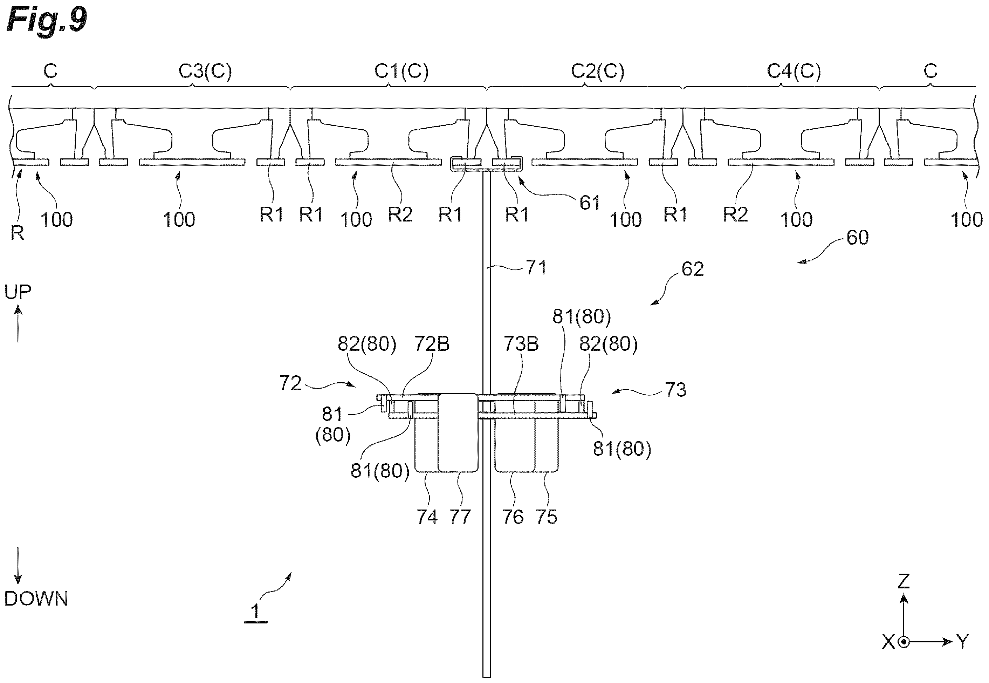

As illustrated in FIG. 9, FIG. 10(a), and FIG. 10(b), from the semi-deployed state, the second movable beam 73B is rotated around the hinge 73C clockwise in plan view and the second movable beam 73B is folded and in the closed state, so that it is possible to deform the body 62 to the next retracted state (two-cell type). In the retracted state, the obstacle sensor S1 of the overhead traveling vehicle 2 traveling along the first and the second travel routes respectively passing through the first and the second cells C1, C2 is capable of respectively detecting the first and the second reflectors 74, 75, and the obstacle sensor S1 of the overhead traveling vehicle 2 traveling along the third and the fourth travel routes respectively passing through the third and the fourth cells C3, C4 is unable to detect the third and the fourth reflectors 76, 77.

In the retracted state, when the overhead traveling vehicle 2 comes into contact with the body 62, the pusher 80 is capable of pressing down the tape switch 12c of the overhead traveling vehicle 2 to stop the overhead traveling vehicle 2 in an emergency. In the retracted state, the second pusher 82 of the first fixed beam 72A functions as a stopper and prevents the first movable beam 72B from rotating more than necessary counterclockwise in plan view, and the second pusher 82 of the second fixed beam 73A functions as a stopper and prevents the second movable beam 73B from rotating more than necessary clockwise in plan view. In the retracted state, the first and the second movable beams 72B, 73B are disposed so as to overlap each other in plan view, and their width in the front-back direction is reduced.

The following describes a use example of the overhead traveling vehicle stopping device 60. First, for example, a user grasps the lower end of the pole 71 and advances the engagement part 61 into the gap G between the first rail R1 and the intersection rail R3 so that the contact portions 61A of the engagement part 61 are in a state of being located above the pair of first rails R1, R1. In this state, after the pole 71 is moved along the first rail R1 so that the engagement part 61 is located in the center of the pair of first rails R1, R1, the contact portions 61A are in contact with the upper surfaces of the pair of first rails R1, R1 and engaged, and the overhead traveling vehicle stopping device 60 is suspended from the pair of first rails R1, R1.

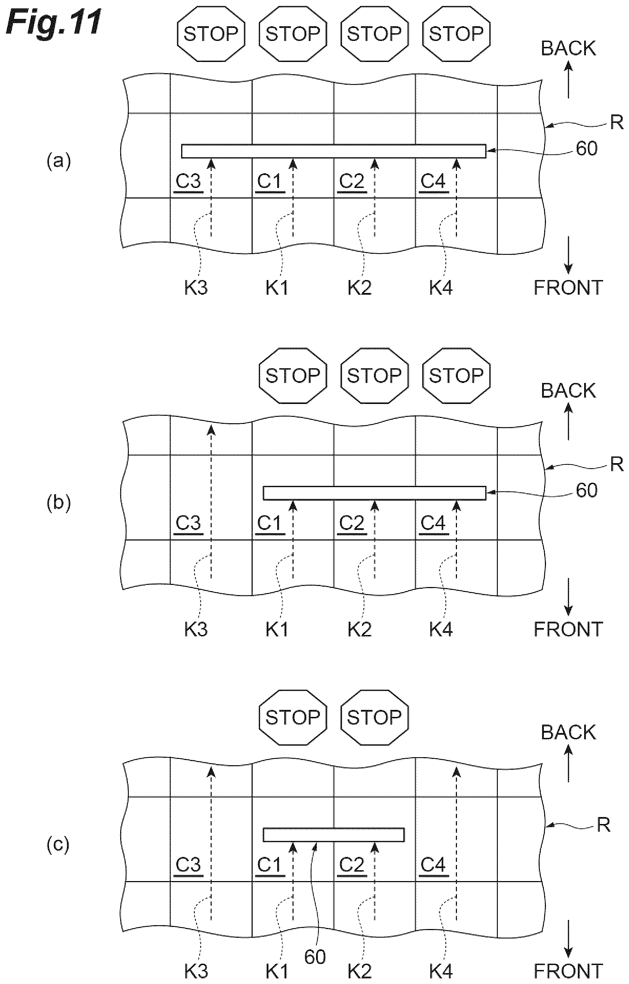

Then, as illustrated in FIG. 11(a), in the case of blockading four parallel first to fourth travel routes K1 to K4, for example, the first and the second beams 72, 73 are not folded and the body 62 is in the fully deployed state. This makes it possible to stop the traveling of the overhead traveling vehicle 2 along the first to the fourth travel routes. On the other hand, as illustrated in FIG. 11(b), in the case of blockading three parallel first travel route K1, second travel route K2, and fourth travel route K4, for example, the first beam 72 is folded and the second beam 73 is not folded, and the body 62 is in the semi-deployed state. This makes it possible to stop the traveling of the overhead traveling vehicle 2 along the first travel route K1, second travel route K2, and fourth travel route K4. On the other hand, as illustrated in FIG. 11(c), in the case of blockading two parallel first and second travel routes K1 and K2, the first and the second beams 72, 73 are folded and the body 62 is in the retracted state. This makes it possible to stop the traveling of the overhead traveling vehicle 2 along the first and the second travel routes K1 and K2.

As described above, in the overhead traveling vehicle stopping device 60, when the engagement part 61 is engaged with the grid rail R in the case where the overhead traveling vehicle 2 travels along the first travel route K1, the first reflector 74 is detected by the obstacle sensor S1, and the traveling is stopped based on the detection result. In the case where the overhead traveling vehicle 2 travels along the second travel route K2, the second reflector 75 is detected by the obstacle sensor S1, and the traveling is stopped based on the detection result. Therefore, it is possible to prohibit passage of the first and the second travel routes K1, K2 that are parallel to each other at the points at which the passage is to be prohibited, without having a plurality of stopping devices to be prepared and installed on the grid rail **R.** In other words, it is possible to easily subject the overhead traveling vehicles 2 to passage prohibition at a plurality of points on the travel route.

In the overhead traveling vehicle stopping device 60, the pole 71 has a bar shape and the first to the fourth reflectors 74 to 77 has a flat plate shape. In this case, the pole 71 and the first to the fourth reflectors 74 to 77 can be configured in an uncomplicated (simple) manner.

In the overhead traveling vehicle stopping device 60, the body 62 includes the first and the second beams 72, 73. The first reflector 74 is provided on the first beam 72. The second reflector 75 is provided on the second beam 73. In this case, the first and the second beams 72, 73 may be used to dispose the first and the second reflectors 74, 75.

In the overhead traveling vehicle stopping device 60, the body 62 includes the pusher 80. This makes it possible to turn off the power of the overhead traveling vehicle 2 coming into contact with the body 62 by the pusher 80, to forcibly stop the overhead traveling vehicle 2, even if the first to the fourth reflectors 74 to 77 could not be detected due to malfunction of the obstacle sensor S1 or the like, for example, and the overhead traveling vehicle 2 could not be stopped. It is possible to reliably subject the overhead traveling vehicles 2 to passage prohibition at a plurality of points on the travel route.

The overhead traveling vehicle stopping device 60 is configured such that at least one of the first to the fourth reflectors 74 to 77 are removable from the body 62. This makes it possible to easily adjust the points at which the overhead traveling vehicles 2 are subjected to passage prohibition based on the detection results of the obstacle sensor S1. Adjustment of the points at which the overhead traveling vehicles 2 are subjected to passage prohibition based on the detection results of the obstacle sensor S1 can also be performed by directly attaching and detaching at least one of the first to the fourth reflectors 74 to 77 to and from the body 62.

The traveling vehicle system 1 includes the grid rail R, the overhead traveling vehicle 2 traveling along the travel route configured by the grid rail R, and the overhead traveling vehicle stopping device 60. In the traveling vehicle system 1, the overhead traveling vehicle stopping device 60 makes it possible to easily subject the overhead traveling vehicle 2 to passage prohibition at a plurality of points on the travel route.

In the traveling vehicle system **1,** the first reflector 74 is detected by the obstacle sensor S1 of the overhead traveling vehicle 2 in the case where the overhead traveling vehicle 2 travels along the first travel route K1 passing through the first cell C1 of the grid rail **R.** The second reflector 75 is detected by the obstacle sensor S1 of the overhead traveling vehicle 2 in the case where the overhead traveling vehicle 2 travels along the second travel route K2 passing through the second cell C2 of the grid rail **R.** The third reflector 76 is detected by the obstacle sensor S1 of the overhead traveling vehicle 2 in the case where the overhead traveling vehicle 2 travels along the third travel route K3 passing through the third cell C3 of the grid rail **R.** The fourth reflector 77 is detected by the obstacle sensor S1 of the overhead traveling vehicle 2 in the case where the overhead traveling vehicle 2 travels along the fourth travel route K4 passing through the fourth cell C4 of the grid rail **R.** In this case, the overhead traveling vehicle stopping device 60 makes it possible to subject each of the first to the fourth travel routes K1 to K4 that are parallel to each other to passage prohibition in the so-called grid system.

In the traveling vehicle system **1,** the body 62 is deformable between the fully deployed state, the semi-deployed state, and the retracted state. In this case, it is possible to easily adjust the points at which the overhead traveling vehicles 2 are subjected to passage prohibition.

In the traveling vehicle system **1,** the body 62 includes the first and the second beams 72, 73 extending from the pole 71 in the left-right direction. The first beam 72 includes the first fixed beam 72A and the first movable beam 72B foldably connected via the first hinge 72C to the tip side of the first fixed beam 72A. The second beam 73 includes the second fixed beam 73A and the second movable beam 73B foldably connected via the second hinge 73C to the tip side of the second fixed beam 73A. The first reflector 74 is provided on the first fixed beam 72A, the second reflector 75 is provided on the second fixed beam 73A, the third reflector 76 is provided on the first movable beam 72B, and the fourth reflector 77 is provided on the second movable beam 73B. In this case, adjusting easily the points at which the overhead traveling vehicles 2 are subjected to passage prohibition is specifically implementable with the folding structure. In addition, the overhead traveling vehicle stopping device 60 being foldable when carried facilitates the handling of the overhead traveling vehicle stopping device 60.

In the traveling vehicle system 1, the first movable beam 72B rotates around the first hinge 72C counterclockwise in plan view, and the second movable beam 73B rotates around the second hinge 73C clockwise in plan view. The connecting part 91 of the first beam 72 in the pole 71 is separated from the connecting part 92 of the second beam 73 in the pole 71 in the up-down direction. In this case, the first and the second movable beams 72B, 73B can be folded so as to overlap each other in plan view. The thickness of the overhead traveling vehicle stopping device 60 in the retracted state can be reduced.

In the traveling vehicle system 1, the engagement part 61 engages to the pair of first rails R1, R1. The engagement part 61 is passable through the gap G in the up-down direction and has a C-shape open upwardly when viewed from the direction along the pair of first rails R1, R1. The engagement part 61 includes the contact portions 61A being in contact with the upper surfaces of the pair of first rails R1, R1. In this case, engagement of the engagement part 61 to the grid rail R is specifically implementable in the so-called grid system. By simply hooking the engagement part 61 to the pair of first rails R1, R1, it is possible to attach the overhead traveling vehicle stopping device 60 to the grid rail **R.**

In the overhead traveling vehicle stopping device 60, the third reflector 76 is provided on the front side of the first movable beam 72B and the fourth reflector 77 is provided on the rear side of the second movable beam 73B in the fully deployed state. This makes it possible to prevent the third and the fourth reflectors 76, 77 from being damaged by interfering with the other members when the first movable beam 72B is folded first during folding of the overhead traveling vehicle stopping device 60 from the fully deployed state to the retracted state.

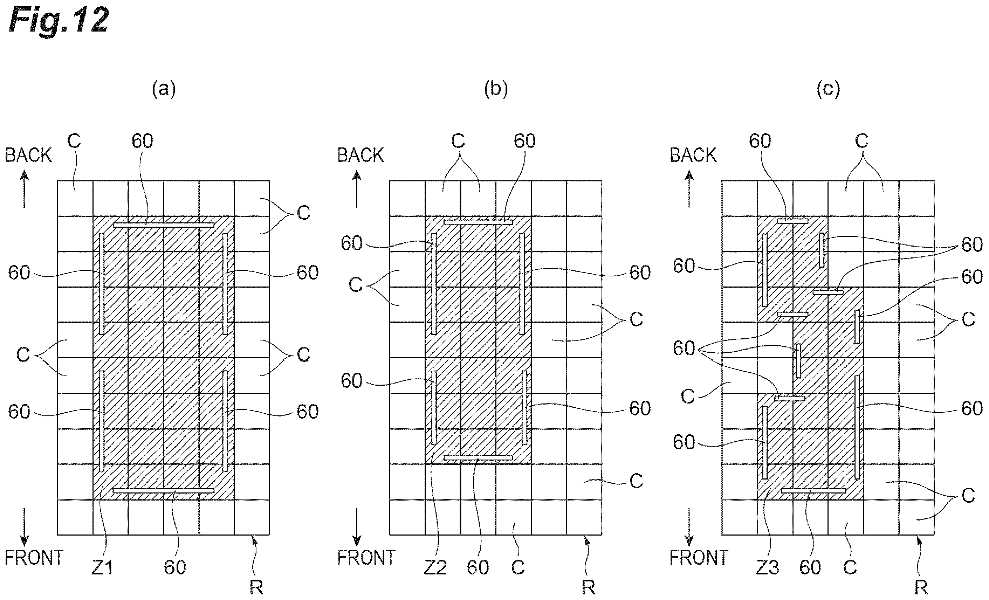

FIG. 12(a), FIG. 12(b), and FIG. 12(c) are plan views of the grid rail R for explaining a use example of the overhead traveling vehicle stopping device 60. In each of the drawings, one square corresponds to one cell C in the grid rail R. As illustrated in FIG. 12(a), in the case of applying passage prohibition to an area Z1 in which the cells C are aligned by eight in front to back and four in left to right, the passage prohibition is implementable by using the six overhead traveling vehicle stopping devices 60 in the fully deployed state. As illustrated in FIG. 12(b), in the case of applying passage prohibition to an area Z2 in which the cells C are aligned by seven in front to back and four in left to right, the passage prohibition is implementable by using the two overhead traveling vehicle stopping devices 60 in the fully deployed state and the four overhead traveling vehicle stopping devices 60 in the semi-deployed state. As illustrated in FIG. 12(c), even in the case of applying passage prohibition for a complicated area Z3, the passage prohibition is implementable by using the overhead traveling vehicle stopping devices 60 in the fully deployed state, the semi-deployed state, and the retracted state as appropriate.

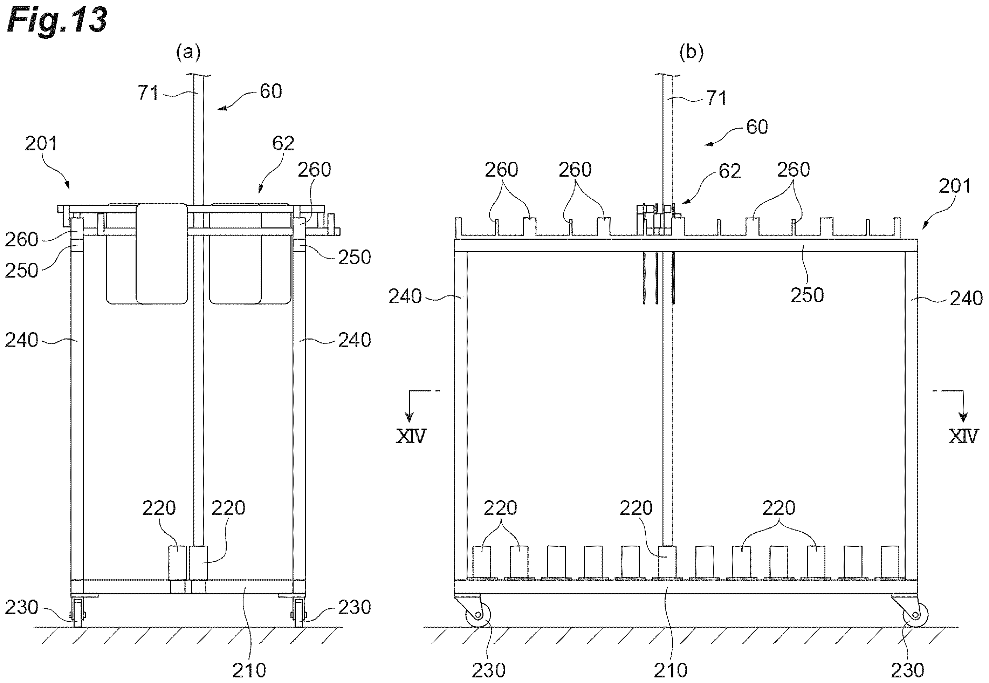

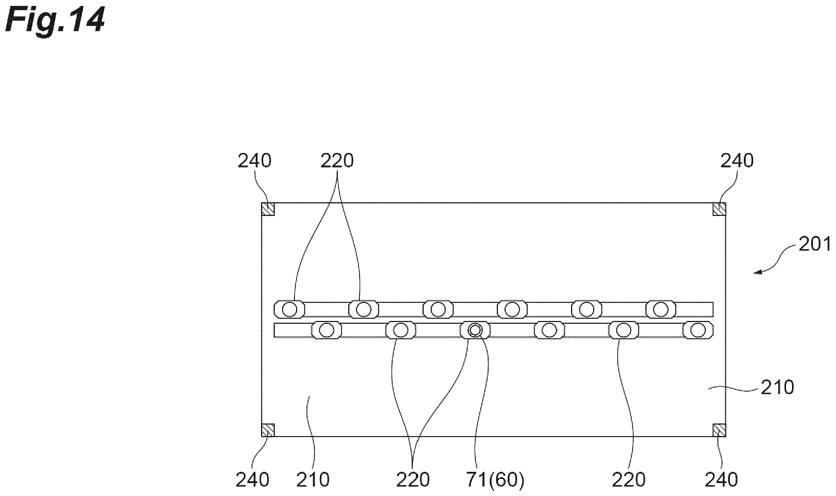

FIG. 13(a), FIG. 13(b), and FIG. 14 are each a view illustrating the cart 201 configured to accommodate the overhead traveling vehicle stopping devices 60. The cart 201 is a transport tool configured to carry a plurality of the overhead traveling vehicle stopping devices 60 in a standing state. The cart 201 has a base 210 of a rectangular plate shape, a plurality of pole stands 220 arranged in two rows along a predetermined direction on the base 210, a plurality of casters 230 fixed to the lower surface of the base 210, pillars 240 erected at the four corners on the base 210, girder members 250 connected to respective upper parts of a pair of the pillars 240 facing each other in a predetermined direction, and dividing members 260 extending so as to bridge the pair of girder members 250 and being aligned at intervals in a predetermined direction.

Into the pole stand 220, the lower part of the pole 71 of the overhead traveling vehicle stopping device 60 is insertable. The pole stand 220 supports the pole 71. In plan view, the plurality of pole stands 220 in one row and the plurality of pole stands 220 in the other row are aligned in parallel to each other with a shift in a predetermined direction. Intervals of the plurality of dividing members 260 correspond to intervals of the plurality of pole stands 220 in a predetermined direction.

In such cart 201, the lower part of the pole 71 of the overhead traveling vehicle stopping device 60 in the retracted state is inserted into and supported by the pole stand 220. Along with this, the first and the second beams 72, 73 that have been folded are disposed between the pair of dividing members 260 and regulated so that the first and the second beams 72, 73 do not move in a predetermined direction. This allows the overhead traveling vehicle stopping device 60 to be transportably accommodated by the cart 200.

As described above, the embodiment according to the present invention has been described, but an aspect of the present invention is not limited to the above-described embodiment, and various modifications can be made within the scope not departing from the gist of the present invention.

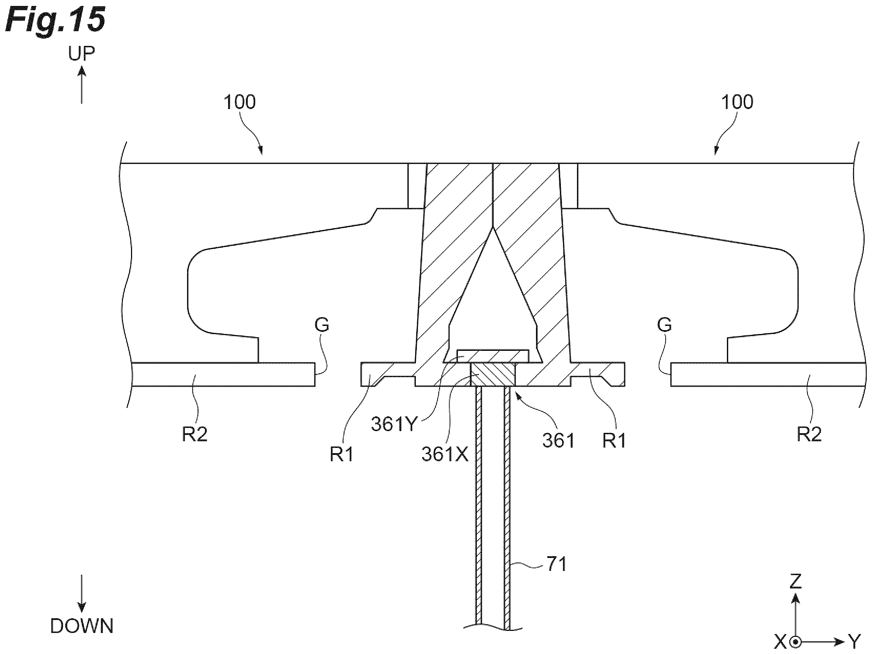

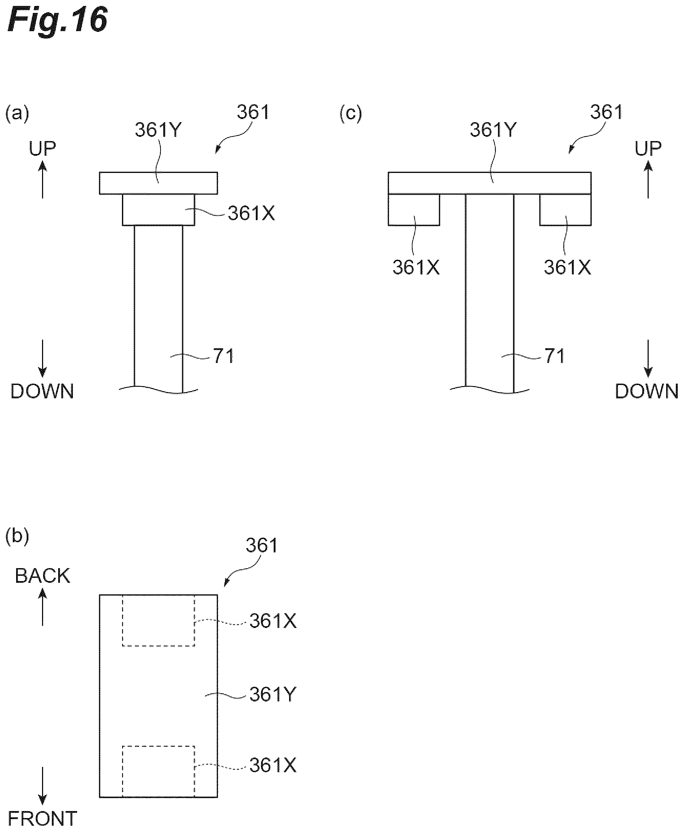

In the above embodiment, the engagement part 61 with a C-shaped hook is employed, but an aspect of the engagement part 61 is not limited. For example, an engagement part 361 with a T-shaped hook illustrated in FIG. 15, FIG. 16(a), FIG. 16(b), and FIG. 16(c) may be employed. The engagement part 361 engages to the pair of first rails R1, R1 extending along the same direction and aligned so as to be close to each other. The engagement part 361 includes an insertion part 361X configured to be inserted between the pair of first rails R1, R1, and contact portions 361Y configured to be connected to the upper side of the insertion part 361X and be in contact with the upper surface of each of the pair of first rails R1, R1; in which the insertion part 361X is a member having a rectangular-shape. The contact portion 361Y is a member of a rectangular plate-shape. The insertion part 361X is provided at both ends of the lower surface of the contact portion 361Y in the longitudinal direction. The upper end of the pole 71 is fixed to the center of the lower surface of the contact portion 361Y. The axial direction of the pole 71 is orthogonal to the lower surface of the contact portion 361Y.

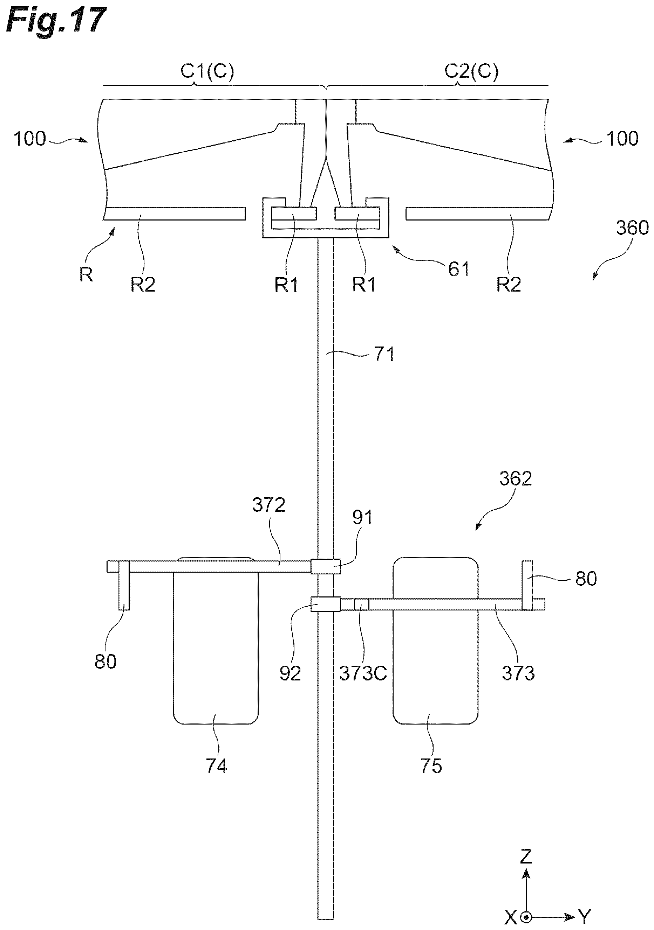

In the above embodiment or the modification, the four parallel first to the fourth travel routes K1-K4 can be blockaded, but are not limited to this. In the above embodiment, it is sufficient that a plurality of parallel travel routes can be blockaded, and, for example, two parallel first and second travel routes K1, K2 may be blockaded, as in the overhead traveling vehicle stopping device 360 shown in FIG. 17.

The overhead traveling vehicle stopping device 360 includes a body 362 in place of the body 62 (see FIG. 3). The body 362 includes a first beam (first arm member) 372, a second beam (second arm member) 373, the first reflector (first detectable portion) 74, the second reflector (second detectable portion) 75, and a plurality of the pushers (push-down parts) 80.

The first beam 372 is a circular tubular member extending from the pole 71 to one side in the left-right direction. The base side of the first beam 372 is fixed to the pole 71 via the connecting part 91. The first beam 372 is located directly below the first cell C1. The first beam 372 is provided with the first reflector 74 and the pushers 80. The second beam 373 is a circular tubular member extending from the pole 71 to the other side in the left-right direction. The base side of the second beam 373 is fixed to the pole 71 via the connecting part 92 and a hinge 373C.

The second beam 373 moves in a pivoting motion with a shaft along the up-down direction of the hinge 373C as a base axis. Specifically, the second beam 373 is movable such that its tip moves counterclockwise and clockwise toward a front side in plan view. This makes it possible to configure the second beam 373 so as to be foldable via the hinge 373C. The second beam 373 is located directly below the second cell C2 in the open state, which is a state of extending in parallel to the first beam 372 (a state in which the second beam 373 is not folded). The second beam 373 is provided with the second reflector 75 and the pushers 80. A hinge 372C is not limited to any particular hinge, and for example, a torque hinge may be used.

The body 362 is, when the second beam 373 is in the open state, in a deployed state in which the obstacle sensor S1 of the overhead traveling vehicle 2 traveling along the second travel route is capable of detecting the second reflector 75. On the other hand, the body 362 is, when the second beam 373 is folded, in the retracted state in which the obstacle sensor S1 of the overhead traveling vehicle 2 traveling along the second travel route is unable to detect the second reflector 75. Thus, the overhead traveling vehicle stopping device 360 is deformable between the deployed state and the retracted states. As described above, according to the overhead traveling vehicle stopping device 360, it is possible to adjust the points at which the overhead traveling vehicles 2 are subjected to passage prohibition.

In the above embodiment or the modification, the layout of the first rail R1, the second rail R2, and the intersection rail R3 is not particularly limited, and various layouts may be adopted. In the above embodiments or variations, the engagement part 61 is engaged with the pair of first rails R1, R1 aligned so as to be close to or come into contact with each other, but is not limited to this. The engagement part in one manner may, for example, be engaged with the pair of second rails R2 aligned so as to be close to or come into contact with each other, or may be engaged with the intersection rail R3, or may be engaged with one first rail R1 or second rail R2.

In the above embodiment or the modification, the first to the fourth detectable portions are the first to the fourth reflectors 74 to 77, but are not limited to this. The first to the fourth detectable portions may be, for example, block-shaped objects. At least two of the first to the fourth detectable portions may be configured as an integral part of each other. In the above embodiment or the modification, a circular tubular member was used as the pusher 80, but the shape of the pusher 80 is not limited and may be of various shapes.

In the above embodiment or the modification, the grid rail R is configured by suspending the rail units 100 from the ceiling while connecting them together, but is not limited to this. For example, the first rail R1, the second rail R2, and the intersection rail R3 may be suspended directly from the ceiling by a hanging member or the like without unitization.

In the above embodiment or the modification, the overhead traveling vehicle stopping device 60 subject the first and the second travel routes corresponding to the rails (here, the pair of the first rails R1, R1) engaged by the engagement part 61 to at least passage prohibition, but is not limited to this. For example, a travel route that does not correspond to the first rail R1 or the second rail R2 to which the engagement part 61 is engaged may be as passage prohibition.

In the above embodiment or the modification, the grid system is employed as the traveling vehicle system 1, but the traveling vehicle system 1 is not limited to the grid system. The traveling vehicle system may include one-way rails preinstalled for allowing the overhead traveling vehicles to travel thereon. In this case, for example, the overhead traveling vehicle stopping device is attached to a one-way first rail or a one-way second rail parallel to the first rail, to stop the traveling of the overhead traveling vehicle along the first and the second travel routes configured by the first and the second rails.

Each configuration in the above embodiment or the modification can be arbitrarily applied to each configuration in other embodiments or modifications. Some of each configuration in the above embodiment or the modification can be omitted as appropriate to the extent that it does not depart from the gist of one aspect of the invention. The present invention is not limited to the above embodiment, and various changes can be made without departing from the intent of the invention.

### Reference Signs List

1... Traveling vehicle system
2... Overhead traveling vehicle
12c... Tape switch (power switch)
60, 360... Overhead traveling vehicle stopping device
61A... Contact portion
61, 361... Engagement part
62, 362... Body
71... Pole (elongated member)
72, 372... First beam (first arm member)
72A... First movable beam (first movable part)
72B... First fixing beam (first fixed part)
72C... Hinge (first hinge)
73, 373... First beam (second arm member)
73A... Second movable beam (second movable part)
73B... Second fixing beam (second fixed part)
73C... Hinge (second hinge)
74... First reflector (first detectable portion)
75... Second reflector (second detectable portion)
76... Third reflector (third detectable portion)
77... Fourth reflector (fourth detectable portion)
80... Pusher (push-down part)
91... Connecting part (connecting point)
92... Connecting part (connecting point)
361X... Insertion part
361Y... Contact portion
C... Cell
G... Gap
K1... First travel route
K2... Second travel route
K3... Third travel route
K4... Fourth travel route
R... Grid rail (rail)
R1... First rail (first straight rail, straight rail)
R2... Second rail (second straight rail, straight rail)
R3... Intersection rail
S1... Obstacle sensor

## Claims

1. An overhead traveling vehicle stopping device attached to rails provided on a ceiling and configured to stop an overhead traveling vehicle traveling along a travel route constituted by the rails, the overhead traveling vehicle stopping device comprising:
an engagement part that is engageable with the rail; and
a body that includes an elongated member that extends downwardly from the engagement part, wherein
the body includes
a first detectable portion configured to be detected by an obstacle sensor of the overhead traveling vehicle traveling along a first travel route in the travel route, and
a second detectable portion configured to be detected by the obstacle sensor of the overhead traveling vehicle traveling along a second travel route parallel to the first travel route in the travel route.

2. The overhead traveling vehicle stopping device according to claim 1, wherein
the elongated member has a bar shape,
the first detectable portion has a plate shape with a thickness direction as a traveling direction of the first travel route, and
the second detectable portion has a plate shape with a thickness direction as the traveling direction of the first travel route.

3. The overhead traveling vehicle stopping device according to claim 1 or **2,** wherein
the body includes a first arm member and a second arm member that extend from the elongated member along a direction intersecting the elongated member,
the first detectable portion is provided in the first arm member, and
the second detectable portion is provided in the second arm member.

4. The overhead traveling vehicle stopping device according to claim 1 or **2,** wherein the body is deformable between a deployed state in which the obstacle sensor of the overhead traveling vehicle traveling along the second travel route is capable of detecting the second detectable portion and a retracted state in which the obstacle sensor of the overhead traveling vehicle traveling along the second travel route is unable to detect the second detectable portion.

5. The overhead traveling vehicle stopping device according to claim 1 or **2,** wherein the body includes a push-down part that is configured to depress, when coming into contact with an overhead traveling vehicle, a power switch of the overhead traveling vehicle.

6. The overhead traveling vehicle stopping device according to claim 1 or **2,** wherein at least one of the first detectable portion and the second detectable portion is configured to be removable from the body.

7. A traveling vehicle system comprising:
rails that are provided on a ceiling and at least partly disposed in a grid;
an overhead traveling vehicle that is configured to travel along the travel route configured by the rails; and
the overhead traveling vehicle stopping device according to claim 1 or 2 that is configured to cause the overhead traveling vehicle traveling along the traveling route to stop.

8. The traveling vehicle system according to claim 7, wherein
the rails include a plurality of first straight rails that extend in a first direction, the first direction being a horizontal direction, and a plurality of second straight rails that extend in a second direction, the second direction being a horizontal direction orthogonal to the first direction;
when a rectangular area enclosed by a pair of the first straight rails and a pair of the second straight rails is considered as one cell in plan view,
the first detectable portion is detected by the obstacle sensor of the overhead traveling vehicle traveling along a first travel route, the first travel route being the travel route passing through a first cell,
the second detectable portion is detected by the obstacle sensor of the overhead traveling vehicle traveling along a second travel route, the second travel route being the travel route passing through a second cell adjacent to the first cell; and
the body includes
a third detectable portion configured to be detected by the obstacle sensor of the overhead traveling vehicle traveling along a third travel route, the third travel route being the travel route passing through a third cell adjacent to the first cell on an opposite side to a second cell side, and
a fourth detectable portion configured to be detected by the obstacle sensor of the overhead traveling vehicle traveling along a fourth travel route, the fourth travel route being the travel route passing through a fourth cell adjacent to the second cell on an opposite side to a first cell side.

9. The traveling vehicle system according to claim 8, wherein the body is deformable between a first deployed state in which the obstacle sensor of the overhead traveling vehicle traveling along the third travel route is capable of detecting the third detectable portion and the obstacle sensor of the overhead traveling vehicle traveling along the fourth travel route is capable of detecting the fourth detectable portion, a second deployed state in which the obstacle sensor of the overhead traveling vehicle traveling along the third travel route is unable to detect the third detectable portion and the obstacle sensor of the overhead traveling vehicle traveling along the fourth travel route is capable of detecting the fourth detectable portion, and a retracted state in which the obstacle sensor of the overhead traveling vehicle traveling along the third travel route is unable to detect the third detectable portion and the obstacle sensor of the overhead traveling vehicle traveling along the fourth travel route is unable to detect the fourth detectable portion.

10. The traveling vehicle system according to claim 9, wherein
the body includes a first arm member and a second arm member that extend from the elongated member along a direction intersecting the elongated member,
the first arm member includes a first fixed part and a first movable part that is foldably connected to a tip side of the first fixed part via a first hinge,
the second arm member includes a second fixed part and a second movable part that is foldably connected to a tip side of the second fixed part via a second hinge,
the first detectable portion is provided on the first fixed part,
the second detectable portion is provided on the second fixed part,
the third detectable portion is provided on the first movable part, and
the fourth detectable portion is provided on the second movable part.

11. The traveling vehicle system according to claim 10, wherein
the first movable part rotates about the first hinge in one rotation direction from between either clockwise or counterclockwise in plan view,
the second movable part rotates about the second hinge in another rotation direction from between either clockwise or counterclockwise in plan view, and
the connecting point of the first arm member at the elongated member is separated from the connecting point of the second arm member at the elongated member in a longitudinal direction of the elongated member.

12. The traveling vehicle system according to claim 7, wherein
the rails include
a plurality of straight rails and
an intersecting rail that is disposed so as to be adjacent to each of ends of the straight rails in a horizontal direction with a gap, and
the engagement part
is engaged with a pair of the straight rails that extend in a same direction and are aligned so as to be close to or come into contact with each other,
is passable through the gap in a vertical direction, has a C-shape open upwardly when viewed from a direction along the pair of straight rails, and
includes a contact portion that is in contact with an upper surface of each of the pair of straight rails.

13. The traveling vehicle system according to claim 7, wherein
the rails include a plurality of straight rails, and
the engagement part
is engaged with a pair of the straight rails that extend in a same direction and are aligned so as to be close to each other, and
includes an insertion part that is inserted between the pair of straight rails and a contact portion that is connected to an upper side of the insertion part and in contact with an upper surface of each of the pair of straight rails.
